# EUROPEAN PATENT APPLICATION

(11) **EP 4 580 033 A1**
(43) Date of publication of application: **02.07.2025**
(21) Application number: 23857431.3
(22) Date of filing: 25.08.2023
(51) Int. Cl.: H02N 11/00, H10N 10/13, H10N 10/17, H10N 10/851, H10N 10/855, H10N 10/856, H10N 10/857

(54) **THERMOELECTRIC POWER GENERATION MODULE**

(30) Priority: 25.08.2022 JP 2022134171; 14.08.2023 JP 2023132040
(71) Applicant: Mitsubishi Materials Corporation, Tokyo 100-8117 (JP); NATIONAL UNIVERSITY CORPORATION YOKOHAMA NATIONAL UNIVERSITY, Yokohama-shi Kanagawa 240-8501 (JP)
(72) Inventor: ARAI, Koya, Saitama-shi, Saitama 330-8508 (JP); YANO, Masahiro, Naka-shi, Ibaraki 311-0102 (JP); OYA, Takahide, Yokohama-shi, Kanagawa 240-8501 (JP)
(74) Representative: Hoffmann Eitle
(86) International application number: PCT/JP2023/030651
(87) International publication number: WO 2024/043323

(57) **Abstract**

A thermoelectric material-containing porous body (20) made of a porous body containing a thermoelectric material having an absolute value of a Seebeck coefficient of 3 µV/K or more, and a first electrode portion (11) and a second electrode portion (12) connected to the thermoelectric material-containing porous body (20) are provided. One end of the thermoelectric material-containing porous body (20) is an immersion portion (21) that is immersed in a liquid (3), and the other end of the thermoelectric material-containing porous body (20) is a non-immersion portion (22). The liquid (3) is sucked up in the immersion portion (21), the liquid (3) which has been sucked up volatilizes in the non-immersion portion (22), a temperature difference occurs between the one end and the other end of the thermoelectric material-containing porous body (20) due to heat of vaporization in volatilization of the liquid (3), and power is generated by the temperature difference.

## Description

### TECHNICAL FIELD

The present invention relates to a thermoelectric power generation module that generates power by using a temperature difference due to a Seebeck effect.

Priority is claimed on Japanese Patent Application No. 2022-134171 filed on August 25, 2022 and Japanese Patent Application No. 2023-132040 filed on August 14, 2023, the contents of which are incorporated herein by reference.

### BACKGROUND ART

As the above-described thermoelectric power generation module, a module using a thermoelectric conversion element capable of mutually converting thermal energy and electrical energy has been proposed.

The Seebeck effect is a phenomenon in which an electromotive force is generated in a case where a temperature difference occurs at both ends of the thermoelectric conversion element, and the thermal energy is converted into the electrical energy. In recent years, there has been active development of thermoelectric power generation using this effect.

Here, for example, Patent Document 1 and Patent Document 2 propose thermoelectric power generation modules using a carbon nanotube as the above-described thermoelectric conversion element.

In the thermoelectric power generation modules disclosed in Patent Document 1 and Patent Document 2, power is generated by causing a temperature difference to occur between one end and the other end of the thermoelectric conversion element. Therefore, it is necessary to secure a heat source in order to cause the temperature difference to occur.

Therefore, in Non Patent Document 1, a thermoelectric power generation module having a structure in which a through hole is formed in a part of an insulating substrate in which carbon nanotubes are arranged on a surface, and electrodes are arranged at a location where the through hole is formed and a location where the through hole is not formed is proposed.

In the thermoelectric power generation module disclosed in Non Patent Document 1, when being floated on a water surface, water is sucked up at the location where the through hole is formed, and a temperature difference occurs between the location where the through hole is formed and the location where the through hole is not formed in the carbon nanotubes due to heat of vaporization when the water vaporizes, and power is generated by the temperature difference.

### Citation List

### Patent Documents

Patent Document 1: Japanese Patent No. 6553191
Patent Document 2: Japanese Unexamined Patent Application, First Publication No. 2022-041264

### Non Patent Document

Non Patent Document 1: Tomoyuki Chiba, Yuki Amma & Masayuki Takashiri; "Heat source free water floating carbon nanotube thermoelectric generators"; [online]; 2021; nature; Internet <URL: <1>https://www.nature.com/articles/s41598-021-94242-0<2>>

### SUMMARY OF INVENTION

### Technical Problem

By the way, in the thermoelectric power generation module described in Non Patent Document 1, since the insulating substrate on which the carbon nanotubes are arranged is floated on the water surface, the insulating substrate on which the carbon nanotubes are arranged has the same temperature as a water temperature, and a temperature difference occurs only in the carbon nanotubes due to the heat of vaporization. Therefore, in order to improve power generation efficiency, it is necessary to significantly increase the amount of heat of vaporization. In addition, only the heat of vaporization of water from the surface of a part of the insulating substrate floating on the water surface can be used, and efficient power generation cannot be performed.

Further, in the thermoelectric power generation module disclosed in Patent Document 1 and Patent Document 2 and the thermoelectric power generation module disclosed in Non Patent Document 1, since the carbon nanotubes are arranged on the surface of the insulating substrate, the degree of freedom in a shape is low, a structure is complicated, and handling is difficult.

The present invention has been made in view of the above circumstances, and an object of the present invention is to provide a thermoelectric power generation module that has a simple structure, is easy to handle, and is capable of generating power easily and efficiently.

### Solution to Problem

In order to solve the above-described problem, according to Aspect 1 of the present invention, there is provided a thermoelectric power generation module including: a thermoelectric material-containing porous body made of a porous body containing a thermoelectric material having an absolute value of a Seebeck coefficient of 3 µV/K or more; and a first electrode portion and a second electrode portion connected to the thermoelectric material-containing porous body, in which one end of the thermoelectric material-containing porous body is an immersion portion that is immersed in a liquid, and the other end of the thermoelectric material-containing porous body is a non-immersion portion, and the liquid is sucked up in the immersion portion, the liquid which has been sucked up volatilizes in the non-immersion portion, a temperature difference occurs between the one end and the other end of the thermoelectric material-containing porous body due to heat of vaporization in volatilization of the liquid, and power is generated by the temperature difference.

According to the thermoelectric power generation module of Aspect 1 of the present invention, the first electrode portion and the second electrode portion are connected to the thermoelectric material-containing porous body made of a porous body containing a thermoelectric material having an absolute value of a Seebeck coefficient of 3 µV/K or more, one end of the thermoelectric material-containing porous body is an immersion portion that is immersed in a liquid, and a temperature difference occurs between the one end and the other end of the thermoelectric material-containing porous body due to heat of vaporization in volatilization of the liquid sucked up in the immersion portion volatilizes in the non-immersion portion, so that power generation can be performed by the temperature difference. In addition, since one end of the thermoelectric material-containing porous body is used as the immersion portion and the other end is used as the non-immersion portion and is disposed outside the liquid, a temperature difference between the outside air and the liquid can also be used.

In addition, an insulating substrate on which a thermoelectric material or the like is disposed is not necessary, a structure is simple, and handling is easy.

Furthermore, a liquid can be vaporized from an entire surface of a portion of the thermoelectric material-containing porous body which is not immersed in the liquid, the amount of vaporization can be secured, and power generation can be efficiently performed due to a temperature difference caused by heat of vaporization.

Note that, it is preferable that the porous body is a structure body in which a capillary phenomenon occurs. In addition, it is preferable that the porous body is a hygroscopic heat generating body that generates heat by wetting. As a result, a temperature difference between the immersion portion and the non-immersion portion can be increased, and power generation can be efficiently performed.

According to Aspect 2 of the present invention, in the thermoelectric power generation module according to Aspect 1, the thermoelectric material may be a carbon nanotube.

According to the thermoelectric power generation module of Aspect 2 of the present invention, since the thermoelectric material is a carbon nanotube, it is possible to constitute a thermoelectric material-containing porous body by making the carbon nanotube itself have a porous structure, and it is also possible to constitute a thermoelectric material-containing porous body by containing a carbon nanotube in an insulating porous body.

In addition, the liquid can be reliably sucked up from the immersion portion formed at one end of the thermoelectric material-containing porous body, and a temperature difference can be secured between one end and the other end of the thermoelectric material-containing porous body due to heat of vaporization of the liquid.

Further, after use, the thermoelectric material-containing porous body can be incinerated and discarded, and thus environmental load can be reduced.

According to Aspect 3 of the present invention, in the thermoelectric power generation module according to Aspect 1, the thermoelectric material may be an organic thermoelectric material.

According to the thermoelectric power generation module of Aspect 3 of the present invention, since the thermoelectric material is an organic thermoelectric material, it is possible to constitute a thermoelectric material-containing porous body by making the organic thermoelectric material itself have a porous structure, and it is also possible to constitute a thermoelectric material-containing porous body by containing an organic thermoelectric material in an insulating porous body.

In addition, the liquid can be reliably sucked up from the immersion portion formed at one end of the thermoelectric material-containing porous body, and a temperature difference can be secured between one end and the other end of the thermoelectric material-containing porous body due to heat of vaporization of the liquid.

According to Aspect 4 of the present invention, in the thermoelectric power generation module according to Aspect 1, the thermoelectric material may be a nanotube or a nanowire formed of a compound semiconductor or a silicon semiconductor.

According to the thermoelectric power generation module of Aspect 4 of the present invention, since the thermoelectric material is a nanotube or a nanowire formed of a compound semiconductor or a silicon semiconductor, it is possible to constitute a thermoelectric material-containing porous body by making the nanotube or the nanowire itself have a porous structure, and it is also possible to constitute a thermoelectric material-containing porous body by containing the nanotube or the nanowire in an insulating porous body.

In addition, the liquid can be reliably sucked up from the immersion portion formed at one end of the thermoelectric material-containing porous body, and a temperature difference can be secured between one end and the other end of the thermoelectric material-containing porous body due to heat of vaporization of the liquid.

According to Aspect 5 of the present invention, in the thermoelectric power generation module according to any one of Aspect 1 to Aspect 4, the porous body may be any one of paper, thread, nonwoven fabric, cloth, and a lead stick.

According to the thermoelectric power generation module of Aspect 5 of the present invention, since the porous body is any one of paper, thread, nonwoven fabric, cloth, and a lead stick (liquid absorption core), the thermoelectric material-containing porous body can be easily manufactured by containing the thermoelectric material in the paper, the thread, the nonwoven fabric, the cloth, and the lead stick (liquid absorption core).

In addition, the liquid can be reliably sucked up from the immersion portion formed at one end of the thermoelectric material-containing porous body, and a temperature difference can be secured between one end and the other end of the thermoelectric material-containing porous body due to heat of vaporization of the liquid.

According to Aspect 6 of the present invention, in the thermoelectric power generation module according to any one of Aspect 1 to Aspect 5, the liquid may be a volatile liquid that is volatilizable at normal temperature.

According to the thermoelectric power generation module of Aspect 6 of the present invention, since the liquid is a volatile liquid that is volatilizable at normal temperature, the liquid can be vaporized in the non-immersion portion on the other end of the thermoelectric material-containing porous body even in a case of being used at normal temperature, and power generation can be reliably performed due to a temperature difference caused by heat of vaporization.

According to Aspect 7 of the present invention, in the thermoelectric power generation module according to any one of Aspect 1 to Aspect 6, the thermoelectric material-containing porous body may include a p-type thermoelectric material-containing porous body containing a p-type thermoelectric material and an n-type thermoelectric material-containing porous body containing an n-type thermoelectric material, and the p-type thermoelectric material-containing porous body and the n-type thermoelectric material-containing porous body may be connected in series.

According to the thermoelectric power generation module of Aspect 7 of the present invention, since the p-type thermoelectric material-containing porous body and the n-type thermoelectric material-containing porous body are connected in series, it is possible to significantly improve power generation efficiency.

According to Aspect 8 of the present invention, in the thermoelectric power generation module according to any one of Aspect 1 to Aspect 6, thermoelectric material-containing porous body may be either a p-type thermoelectric material-containing porous body containing a p-type thermoelectric material or an n-type thermoelectric material-containing porous body containing an n-type thermoelectric material, and a conductor-containing porous body made of a porous body containing a conductor and the thermoelectric material-containing porous body may be connected to each other.

According to the thermoelectric power generation module of Aspect 8 of the present invention, since the conductor-containing porous body made of a porous body containing a conductor is connected to the thermoelectric material-containing porous body, a liquid can be reliably sucked up from the immersion portion, and a temperature difference can be secured between one end and the other end of the thermoelectric material-containing porous body due to heat of vaporization of the liquid.

According to Aspect 9 of the present invention, the thermoelectric power generation module according to any one of Aspect 1 to Aspect 8 may further include a liquid holding portion that holds the liquid.

According to the thermoelectric power generation module of Aspect 9 of the present invention, since the liquid holding portion that holds the liquid is provided, the liquid is held in the liquid holding portion, and the immersion portion formed on one end of the thermoelectric material-containing porous body is immersed in the liquid, and thus power generation can be performed by a temperature difference due to heat of vaporization.

According to Aspect 10 of the present invention, in the thermoelectric power generation module according to Aspect 9, one end of each of a plurality of the thermoelectric material-containing porous bodies may be immersed in the liquid holding portion, and a partition portion may be provided between immersion portions of the thermoelectric material-containing porous bodies adjacent to each other.

According to the thermoelectric power generation module of Aspect 10 of the present invention, one end of each of the plurality of thermoelectric material-containing porous bodies is immersed in the liquid holding portion, and a partition portion is provided between the immersion portions of the adjacent thermoelectric material-containing porous bodies. Therefore, it is possible to suppress the adjacent thermoelectric material-containing porous bodies from coming into contact with each other to cause short-circuit or from causing short-circuit due to the liquid, and it is possible to significantly improve power generation efficiency.

According to Aspect 11 of the present invention, the thermoelectric power generation module according to any one of Aspect 1 to Aspect 8 may further include a float.

According to the thermoelectric power generation module of Aspect 11 of the present invention, since the float is provided, the thermoelectric power generation module is floated on a liquid surface of an existing liquid storage portion (for example, a pond, a tank, or the like) by using the float, the immersion portion formed on one end of the thermoelectric material-containing porous body is immersed in the liquid, and the non-immersion portion on the other end of the thermoelectric material-containing porous body is disposed to be located outside the liquid, and thus power generation can be performed by a temperature difference due to heat of vaporization.

According to Aspect 12 of the present invention, in the thermoelectric power generation module according to any one of Aspect 1 to Aspect 11, a porous body having a corrugated structure in which one oblique wall portion and the other oblique wall portion are connected to each other may be provided, and at least the one oblique wall portion may be the thermoelectric material-containing porous body.

According to the thermoelectric power generation module of Aspect 12 of the present invention, since the thermoelectric power generation module includes the porous body having the corrugated structure in which one oblique wall portion and the other oblique wall portion are connected to each other, and at least the one oblique wall portion is the thermoelectric material-containing porous body, the structure is simple, and the thermoelectric power generation module can be relatively easily manufactured.

### Advantageous Effects of Invention

According to the present invention, it is possible to provide a thermoelectric power generation module that has a simple structure, is easy to handle, and is capable of performing power generation easily and efficiently.

### BRIEF DESCRIPTION OF DRAWINGS

[FIG. 1] A schematic explanatory view of a thermoelectric power generation module according to a first embodiment of the present invention.
[FIG. 2] A schematic explanatory view representing a method of manufacturing a thermoelectric material-containing porous body used in the thermoelectric power generation module of the present invention.
[FIG. 3] A schematic explanatory view of a thermoelectric power generation module according to a second embodiment of the present invention.
[FIG. 4] A schematic explanatory view of a thermoelectric power generation module according to another embodiment of the present invention.
[FIG. 5] A schematic explanatory view of a thermoelectric power generation module according to still another embodiment of the present invention.
[FIG. 6] A schematic explanatory view of a thermoelectric power generation module according to still another embodiment of the present invention.
[FIG. 7] A schematic explanatory view of a thermoelectric power generation module according to still another embodiment of the present invention.
[FIG. 8] A schematic explanatory view of a thermoelectric power generation module according to still another embodiment of the present invention.
[FIG. 9] A schematic explanatory view of a thermoelectric material-containing porous body according to still another embodiment of the present invention.

### DESCRIPTION OF EMBODIMENTS

Hereinafter, embodiments of the present invention will be described with reference to the accompanying drawings. Note that, the embodiments shown below are specifically described for better understanding of the gist of the invention, and do not limit the present invention unless otherwise specified. In addition, in the drawings used in the following description, in order to facilitate understanding of features of the present invention, for convenience, portions that are main components may be shown in an enlarged manner, and a dimensional ratio or the like of each component may not be the same as an actual one.

### (First Embodiment)

First, a thermoelectric power generation module according to a first embodiment of the present invention will be described.

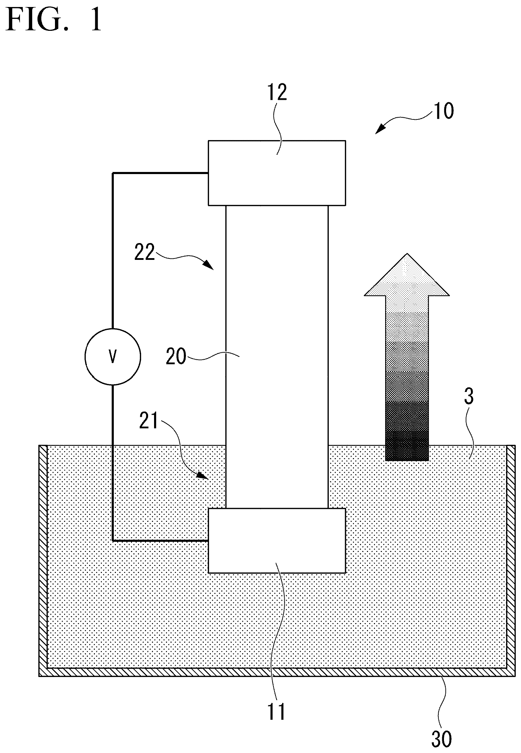

As shown in FIG. 1, a thermoelectric power generation module 10 according to the present embodiment includes a thermoelectric material-containing porous body 20 made of a porous body containing a thermoelectric material having an absolute value of a Seebeck coefficient of 3 µV/K or more, and a first electrode portion 11 and a second electrode portion 12 connected to the thermoelectric material-containing porous body 20.

In addition, in the present embodiment, as shown in FIG. 1, a liquid holding portion 30 that holds a liquid 3 is provided.

It is preferable that the liquid 3 held in the liquid holding portion 30 is a volatile liquid that volatilizes at normal temperature (20°C). Examples of the volatile liquid include water and various alcohols. In the present embodiment, the liquid 3 is water.

Then, one end (lower end in FIG. 1) of the thermoelectric material-containing porous body 20 is an immersion portion 21 that is immersed in the liquid 3, and the other end (upper end in FIG. 1) of the thermoelectric material-containing porous body 20 is a non-immersion portion 22 that is not immersed in the liquid 3.

In the present embodiment, as shown in FIG. 1, the first electrode portion 11 is disposed at one end of the thermoelectric material-containing porous body 20, and the second electrode portion 12 is disposed at the other end of the thermoelectric material-containing porous body 20. That is, in the present embodiment, the first electrode portion 11 is disposed in the liquid 3.

The thermoelectric material-containing porous body 20 is made of a porous body containing a thermoelectric material having an absolute value of a Seebeck coefficient of 3 µV/K or more.

The thermoelectric material having an absolute value of a Seebeck coefficient of 3 µV/K or more has characteristics as a semiconductor, and has characteristics as a p-type semiconductor or an n-type semiconductor. Note that, in the present embodiment, the thermoelectric material-containing porous body 20 may be either the p-type semiconductor or the n-type semiconductor.

Here, examples of the thermoelectric material having an absolute value of a Seebeck coefficient of 3 µV/K or more include (a) a carbon nanotube (CNT), (b) an organic thermoelectric material, (c) a nanotube or nanowire formed of a compound semiconductor or a silicon semiconductor, (d) a noble metal compound, (e) a carbon material, and (f) a metal such as Bi, Co, Fe, or Ni.

Note that, the thermoelectric material contained in the thermoelectric material-containing porous body 20 preferably has an absolute value of a Seebeck coefficient of 40 µV/K or more. In addition, the thermoelectric materials of (a) to (f) may be used in combination.

Here, in a case of (a) the carbon nanotube, the carbon nanotube itself can be made into a porous structure (paper, thread, nonwoven fabric, cloth, a lead stick, and the like) to constitute the thermoelectric material-containing porous body 20. In addition, the thermoelectric material-containing porous body 20 can be formed by containing carbon nanotubes in another porous body.

Note that, the Seebeck coefficient of the carbon nanotube is approximately 5 to 170 µV/K.

(b) Examples of the organic thermoelectric material include a PEDOT-based material (PEDOT:PSS, PEDOT:Tos, and the like), a π-conjugated nickel complex-based material (poly(nickel-ethylenetetrathiolate)), an N-DMBI-based material (N,N-dimethyl-2-phenyl-2,3-dihydro-1H-benzoimidazole), and the like.

Note that, a Seebeck coefficient of PEDOT:PSS is approximately 10 to 100 µV/K. In addition, a Seebeck coefficient of PEDOT:Tos is approximately 40 to 210 µV/K. A Seebeck coefficient of the π-conjugated nickel complex-based material is approximately -16 to -140 µV/K.

In a case of the organic thermoelectric material, the organic thermoelectric material itself can be made into a porous structure (paper, thread, nonwoven fabric, cloth, a lead stick, and the like) to constitute the thermoelectric material-containing porous body 20. In addition, the thermoelectric material-containing porous body 20 can be made of containing an organic thermoelectric material in another porous body.

(c) In a case of the nanotube or a nanowire formed of a compound semiconductor or a silicon semiconductor, the thermoelectric material-containing porous body 20 can be formed by containing one or more of a boron nitride nanotube, a Si nanowire, a Bi₂Te₃ nanowire, or a nanotube or a nanowire formed of a compound semiconductor or a silicon semiconductor in another porous body.

(d) Examples of the noble metal compound include a copper compound, a silver compound, a gold compound, a platinum compound, and the like. Specifically, a compound of a noble metal element (Cu, Ag, Au, or Pt) and S, Se, or Te is preferable.

In a case of the noble metal compound, the thermoelectric material-containing porous body 20 can be made of containing the noble metal compound in another porous body.

(e) Examples of the carbon material include carbon black and graphite. In a case of the carbon material, the thermoelectric material-containing porous body 20 can be made of containing the carbon material in another porous body.

(f) In a case of the metal such as Bi, Co, Fe, and Ni, the thermoelectric material-containing porous body 20 can be made of containing the metal such as Bi, Co, Fe, and Ni in another porous body. Note that, it is preferable that the metal such as Bi, Co, Fe, or Ni is contained in another porous body by a plating method.

**In** the present embodiment, the thermoelectric material-containing porous body 20 is obtained by impregnating a porous body with carbon nanotubes (CNTs), and has characteristics as a semiconductor and characteristics as a p-type semiconductor or an n-type semiconductor. Note that, in the present embodiment, the thermoelectric material-containing porous body 20 may be either the p-type semiconductor or the n-type semiconductor.

As the porous body, fibrous materials such as paper, thread, nonwoven fabric, cloth, and a lead stick are preferable. In the present embodiment, the porous body is paper, and the thermoelectric material-containing porous body 20 is CNT-containing paper. Note that, the fiber may be a natural fiber or a synthetic fiber, and paper, thread, nonwoven fabric, cloth, lead stick, and the like obtained by combining a plurality of fibers may be used.

In addition, the porous body is preferably a structure body in which a capillary phenomenon occurs, and a plate, a film, a net, a hollow fiber, and the like can be used in addition to the paper, the thread, the nonwoven fabric, the cloth, and the lead stick. Note that, the porous body is preferably an insulating porous body. The porous body is preferably a hygroscopic heat generating body, and in a case where the porous body has an effect of heat generation due to a hydration reaction on a material surface which occurs by wetting, or heat generation due to strain release accompanied with swelling of a material, a temperature difference between the porous body and the non-immersion portion 22 can be increased, and power generation can be efficiently performed.

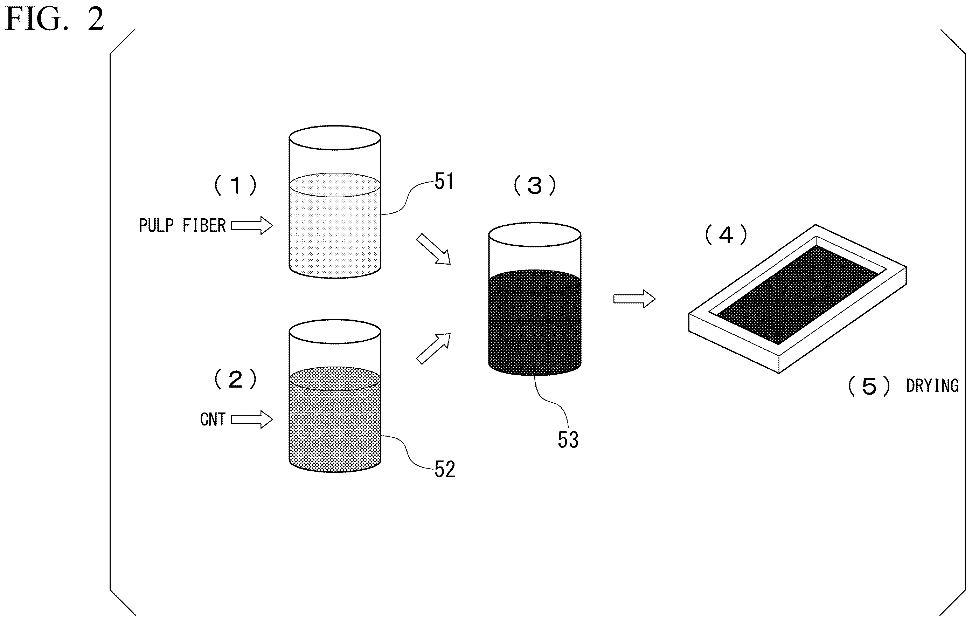

Here, an example of a method of manufacturing the thermoelectric material-containing porous body 20 (CNT-containing paper) will be described with reference to FIG. 2.

As shown in FIG. 2(1), a pulp suspension 51 in which pulp fibers are dispersed is obtained by putting the pulp fibers into pure water and stirring the resultant mixture sufficiently.

In addition, as shown in FIG. 2(2), a carbon nanotube dispersed solution 52 is obtained by putting a single-layer carbon nanotube into pure water and stirring the resultant mixture sufficiently. At this time, the single-layer carbon nanotube is preferably set to a proportion of 0.8% by mass or more and 8.0% by mass or less with respect to the weight of the pulp fibers as a paper raw material. In addition, it is not necessary to add a dispersant. In addition, when obtaining the carbon nanotube dispersed solution 52, it is preferable to perform an ultrasonic treatment for approximately 30 minutes.

Next, as shown in FIG. 2(3), the pulp suspension 51 and the carbon nanotube dispersed solution 52 are mixed and stirred to obtain a mixed solution 53. In this case, the carbon nanotube is attached to a pulp fiber.

Then, as shown in FIGS. 2(4) and 2(5), the above-described mixed solution 53 is subjected to paper filtration and dried to obtain the thermoelectric material-containing porous body 20 (CNT-containing paper).

In the thermoelectric power generation module 10 according to the present embodiment, as shown in FIG. 1, since the one end of the thermoelectric material-containing porous body 20 including the thermoelectric material having an absolute value of a Seebeck coefficient of 3 µV/K or more is the immersion portion 21 that is immersed in the liquid 3, the liquid 3 is sucked up through pore portions of the porous body. The sucked-up liquid 3 moves to the other end of the thermoelectric material-containing porous body 20 and volatilizes in the non-immersion portion 22 disposed outside the liquid 3. The temperature of the non-immersion portion 22 is lowered due to heat of vaporization at this time.

As a result, a temperature difference occurs between the first electrode portion 11 disposed on the one end of the thermoelectric material-containing porous body 20 and the second electrode portion 12 disposed on the other end of the thermoelectric material-containing porous body 20. That is, in the present embodiment, the temperature difference occurs in a direction (a direction away from a liquid surface) intersecting the liquid surface. A potential difference occurs between the first electrode portion 11 and the second electrode portion 12 due to this temperature difference.

In the thermoelectric power generation module 10 according to the present embodiment having the above-described configuration, the first electrode portion 11 is connected to the one end of the thermoelectric material-containing porous body 20 made of a porous body containing a thermoelectric material having an absolute value of a Seebeck coefficient of 3 µV/K or more, the second electrode portion 12 is connected to the other end of the thermoelectric material-containing porous body 20, and a temperature difference occurs between the one end and the other end of the thermoelectric material-containing porous body 20 due to the heat of vaporization in volatilization of the liquid 3 sucked up by the immersion portion 21 of the thermoelectric material-containing porous body 20 volatilizes in the non-immersion portion 22. Therefore, power generation can be performed by the temperature difference.

**In** addition, in the thermoelectric power generation module 10 according to the present embodiment, since the other end of the thermoelectric material-containing porous body 20 is the non-immersion portion 22 and is disposed outside the liquid 3, a temperature difference between the outside air and the liquid 3 can also be used.

Furthermore, the liquid 3 can be volatilized from the entire surface of the non-immersion portion 22 of the thermoelectric material-containing porous body 20 that is not immersed in the liquid 3, the amount of vaporization is large, and power generation can be efficiently performed by the temperature difference due to the heat of vaporization.

In particular, in the present embodiment, since the temperature difference occurs in a direction (a direction away from the liquid surface) intersecting the liquid surface, the liquid 3 can be efficiently vaporized, and the temperature difference between the outside air and the liquid 3 can be further used, so that power generation can be efficiently performed. In addition, in a case where the liquid 3 is hydrophilic, the surface of the thermoelectric material-containing porous body 20 is hydrophilized through addition of a surfactant or irradiation with plasma, so that the liquid 3 can be efficiently sucked up, the temperature difference due to the heat of vaporization can be increased, and power generation can be efficiently performed. In a case where the liquid 3 is hydrophobic, the thermoelectric material-containing porous body 20 may be subjected to a hydrophobic treatment. That is, it is preferable to perform a hydrophilic or hydrophobic surface treatment on the thermoelectric material-containing porous body 20 in accordance with the hydrophilicity and hydrophobicity of the liquid 3.

In addition, in the thermoelectric power generation module 10 according to the present embodiment, since the carbon nanotube is impregnated in the porous body, an insulating substrate on which the carbon nanotube or the like is disposed is not necessary, a structure is simple, and handling is easy.

Further, since a porous body is used, the liquid 3 can be efficiently sucked up in the immersion portion 21 by a capillary phenomenon, and the liquid 3 can efficiently volatilize in the non-immersion portion 22.

In addition, in the thermoelectric power generation module 10 according to the present embodiment, in a case where the porous body is any one of paper, thread, nonwoven fabric, cloth, and a lead stick, the thermoelectric material-containing porous body 20 can be easily manufactured by containing carbon nanotubes in the paper, the thread, the nonwoven fabric, the cloth, and the lead stick. In addition, the liquid 3 can be reliably sucked up from the immersion portion 21 of the thermoelectric material-containing porous body 20.

Further, after use, the thermoelectric material-containing porous body 20 can be incinerated and discarded, and thus environmental load can be reduced.

In addition, in the thermoelectric power generation module 10 according to the present embodiment, in a case where the liquid 3 is a volatile liquid that is volatilizable at normal temperature, the liquid 3 sucked up from the immersion portion 21 of the thermoelectric material-containing porous body 20 can be efficiently vaporized in the non-immersion portion 22 even at normal temperature, and power generation can be performed due to a temperature difference due to heat of vaporization.

Further, in the thermoelectric power generation module 10 according to the present embodiment, in a case where the liquid holding portion 30 that holds the liquid 3 is provided, the immersion portion 21 of the thermoelectric material-containing porous body 20 can be immersed in the liquid 3 held in the liquid holding portion 30. Therefore, the liquid 3 sucked up from the immersion portion 21 of the thermoelectric material-containing porous body 20 can be vaporized in the non-immersion portion 22, and power generation can be performed by a temperature difference due to the heat of vaporization. In addition, as a method of supplying the liquid 3 to the thermoelectric power generation module 10, in addition to a method of pouring an optional amount of the liquid into the liquid holding portion 30, a method of constantly supplying the liquid from a river or the like, or a method of performing immersion by applying vapor to the immersion portion 21 of the thermoelectric material-containing porous body 20 to generate the liquid by condensation and performing power generation by a temperature difference from the non-immersion portion 22 may be used.

### (Second Embodiment)

Next, a thermoelectric power generation module 110 according to a second embodiment of the present invention will be described.

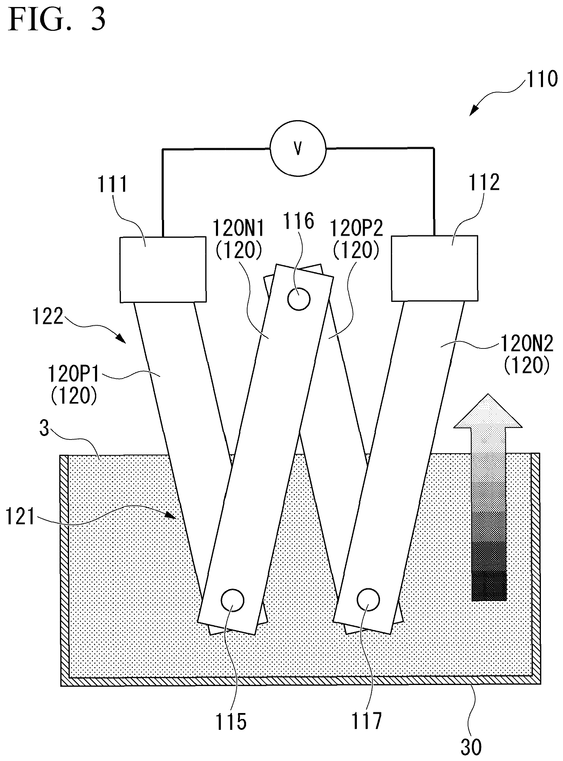

As shown in FIG. 3, the thermoelectric power generation module 110 according to the present embodiment includes a plurality of p-type thermoelectric material-containing porous bodies (a first p-type thermoelectric material-containing porous body 120P1 and a second p-type thermoelectric material-containing porous body 120P2) and a plurality of n-type thermoelectric material-containing porous bodies (a first n-type thermoelectric material-containing porous body 120N1 and a second n-type thermoelectric material-containing porous body 120N2) as a thermoelectric material-containing porous body 120 made of a porous body containing a thermoelectric material having an absolute value of a Seebeck coefficient of 3 µV/K or more.

In the present embodiment, as shown in FIG. 3, one end (a lower end in FIG. 3) of the first p-type thermoelectric material-containing porous body 120P1 and one end (a lower end in FIG. 3) of the first n-type thermoelectric material-containing porous body 120N1 are connected by a first connecting portion 115, the other end (an upper end in FIG. 3) of the first n-type thermoelectric material-containing porous body 120N1 and the other end (an upper end in FIG. 3) of the second p-type thermoelectric material-containing porous body 120P2 are connected by a second connecting portion 116, and one end (a lower end in FIG. 3) of the second p-type thermoelectric material-containing porous body 120P2 and one end (a lower end in FIG. 3) of the second n-type thermoelectric material-containing porous body 120N2 are connected by a third connecting portion 117.

In addition, a first electrode portion 111 is disposed at the other end of the first p-type thermoelectric material-containing porous body 120P1, and a second electrode portion 112 is disposed at the other end of the second n-type thermoelectric material-containing porous body 120N2.

That is, in the present embodiment, the first p-type thermoelectric material-containing porous body 120P1, the first n-type thermoelectric material-containing porous body 120N1, the second p-type thermoelectric material-containing porous body 120P2, and the second n-type thermoelectric material-containing porous body 120N2 are connected in series.

In the present embodiment, one end of the first p-type thermoelectric material-containing porous body 120P1, the first n-type thermoelectric material-containing porous body 120N1, the second p-type thermoelectric material-containing porous body 120P2, and the second n-type thermoelectric material-containing porous body 120N2 is an immersion portion 121 immersed in the liquid 3, and the other end of the first p-type thermoelectric material-containing porous body 120P1, the first n-type thermoelectric material-containing porous body 120N1, the second p-type thermoelectric material-containing porous body 120P2, and the second n-type thermoelectric material-containing porous body 120N2 is a non-immersion portion 122.

Therefore, in the present embodiment, the first connecting portion 115 and the third connecting portion 117 are immersed in the liquid 3, and the second connecting portion 116, the first electrode portion 111, and the second electrode portion 112 are disposed outside the liquid 3.

In the thermoelectric power generation module 110 according to the present embodiment, as shown in FIG. 3, since the first p-type thermoelectric material-containing porous body 120P1, one end of each of the first n-type thermoelectric material-containing porous body 120N1, the second p-type thermoelectric material-containing porous body 120P2, and the second n-type thermoelectric material-containing porous body 120N2 is an immersion portion 121 that is immersed in the liquid 3, the liquid 3 is sucked up through pore portions of the porous body. The sucked-up liquid 3 moves to the other end of the first p-type thermoelectric material-containing porous body 120P1, the first n-type thermoelectric material-containing porous body 120N1, the second p-type thermoelectric material-containing porous body 120P2, and the second n-type thermoelectric material-containing porous body 120N2, and volatilizes in the non-immersion portion 122 disposed outside the liquid 3. A temperature of the non-immersion portion 122 is lowered due to heat of vaporization at this time.

As a result, a temperature difference occurs between the one end and the other end of the first p-type thermoelectric material-containing porous body 120P1, the first n-type thermoelectric material-containing porous body 120N1, the second p-type thermoelectric material-containing porous body 120P2, and the second n-type thermoelectric material-containing porous body 120N2, and power is generated by this temperature difference.

The first p-type thermoelectric material-containing porous body 120P1, the first n-type thermoelectric material-containing porous body 120N1, the second p-type thermoelectric material-containing porous body 120P2, and the second n-type thermoelectric material-containing porous body 120N2 are connected in series, and a potential difference occurs between the first electrode portion 111 connected to the other end of the first p-type thermoelectric material-containing porous body 120P1 and the second electrode portion 112 connected to the other end of the second n-type thermoelectric material-containing porous body 120N2.

In the thermoelectric power generation module 110 according to the present embodiment having the above-described configuration, as in the first embodiment, a temperature difference occurs between the one end and the other end of the first p-type thermoelectric material-containing porous body 120P1, the first n-type thermoelectric material-containing porous body 120N1, the second p-type thermoelectric material-containing porous body 120P2, and the second n-type thermoelectric material-containing porous body 120N2 due to the heat of vaporization of the liquid 3, and power generation can be performed.

In addition, in the present embodiment, since the first p-type thermoelectric material-containing porous body 120P1, the first n-type thermoelectric material-containing porous body 120N1, the second p-type thermoelectric material-containing porous body 120P2, and the second n-type thermoelectric material-containing porous body 120N2 are connected in series, the power generation efficiency can be significantly improved.

Hereinabove, the embodiments of the present invention have been described. However, the present invention is not limited thereto and can be suitably modified without departing from the technical idea of the present invention.

For example, in order to ensure the strength of the thermoelectric power generation module, the thermoelectric material-containing porous body may be disposed on a support (a mounting sheet, a substrate, or the like).

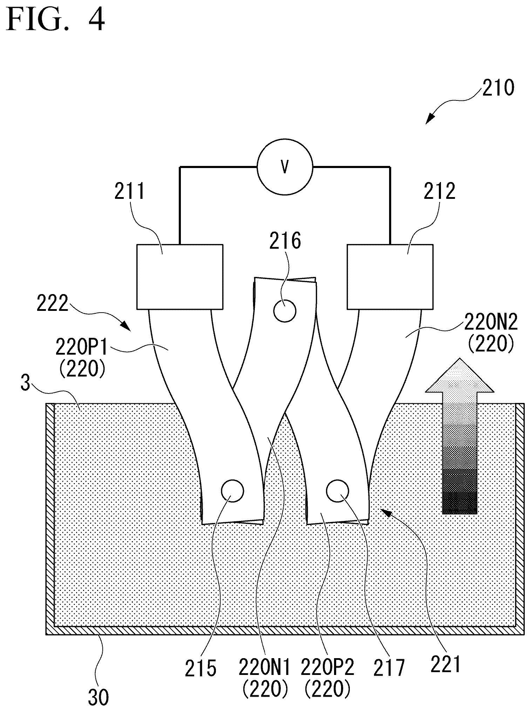

In addition, in the second embodiment of the present invention, the thermoelectric power generation module is described as a module in which a plurality of p-type thermoelectric material-containing porous bodies and a plurality of n-type thermoelectric material-containing porous bodies are arranged in a planar shape and are joined in series, but the present invention is not limited thereto. As in a thermoelectric power generation module 210 shown in FIG. 4, a plurality of p-type thermoelectric material-containing porous bodies (a first p-type thermoelectric material-containing porous body 220P1 and a second p-type thermoelectric material-containing porous body 220P2) and a plurality of n-type thermoelectric material-containing porous bodies (a first n-type thermoelectric material-containing porous body 220N1 and a second n-type thermoelectric material-containing porous body 220N2) may be arranged in a three-dimensional shape and may be joined in series.

In the thermoelectric power generation module 210 shown in FIG. 4, one end of the first p-type thermoelectric material-containing porous body 220P1 and one end of the first n-type thermoelectric material-containing porous body 220N1 are connected by a first connecting portion 215, the other end of the first n-type thermoelectric material-containing porous body 220N1 and the other end of the second p-type thermoelectric material-containing porous body 220P2 are connected by a second connecting portion 216, and one end of the second p-type thermoelectric material-containing porous body 220P2 and one end of the second n-type thermoelectric material-containing porous body 220N2 are connected by a third connecting portion 217.

In addition, a first electrode portion 211 is disposed at the other end of the first p-type thermoelectric material-containing porous body 220P1, and a second electrode portion 212 is disposed at the other end of the second n-type thermoelectric material-containing porous body 220N2.

One end of the first p-type thermoelectric material-containing porous body 220P1, the first n-type thermoelectric material-containing porous body 220N1, the second p-type thermoelectric material-containing porous body 220P2, and the second n-type thermoelectric material-containing porous body 220N2 is an immersion portion 221 that is immersed in the liquid 3, and the other end of the first p-type thermoelectric material-containing porous body 220P1, the first n-type thermoelectric material-containing porous body 220N1, the second p-type thermoelectric material-containing porous body 220P2, and the second n-type thermoelectric material-containing porous body 220N2 is a non-immersion portion 222.

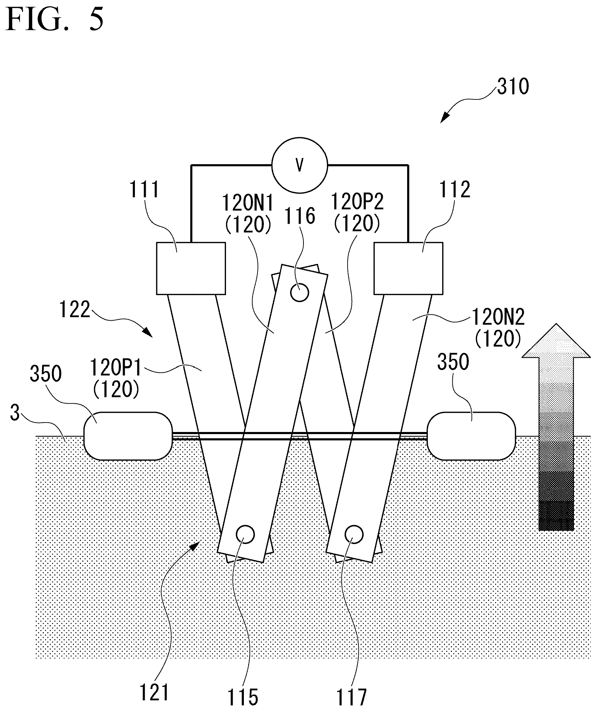

In addition, in the present embodiment, the liquid holding portion 30 is described to be provided, but the present invention is not limited thereto. As in a thermoelectric power generation module 310 shown in FIG. 5, a thermoelectric power generation module 310 including a float 350 may be used, and the thermoelectric power generation module 310 may be disposed on a liquid surface of an existing liquid storage tank, pond, lake, or the like.

Note that, the thermoelectric power generation module 310 shown in FIG. 5 is obtained by removing the liquid holding portion 30 in the thermoelectric power generation module 110 according to the second embodiment of the present invention and disposing the float 350.

Note that, the float 350 may be made of paper, or the float 350 may be made of a porous body constituting the CNT-containing porous body.

In addition, in the first embodiment, as shown in FIG. 1, the first electrode portion 11 is immersed in the liquid 3, but the first electrode portion 11 may not be immersed in the liquid 3 as long as a part of the thermoelectric material-containing porous body 20 is immersed in the liquid 3 and a distance from the liquid surface to the first electrode portion 11 and a distance from the liquid surface to the second electrode portion 12 are different from each other.

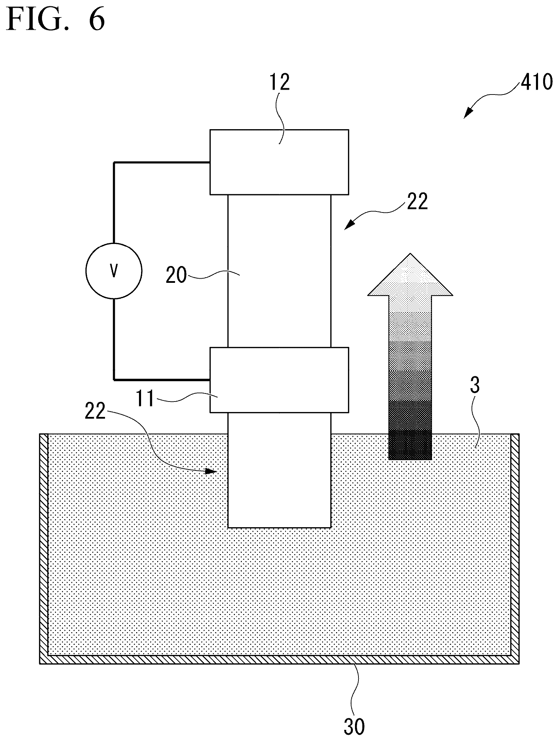

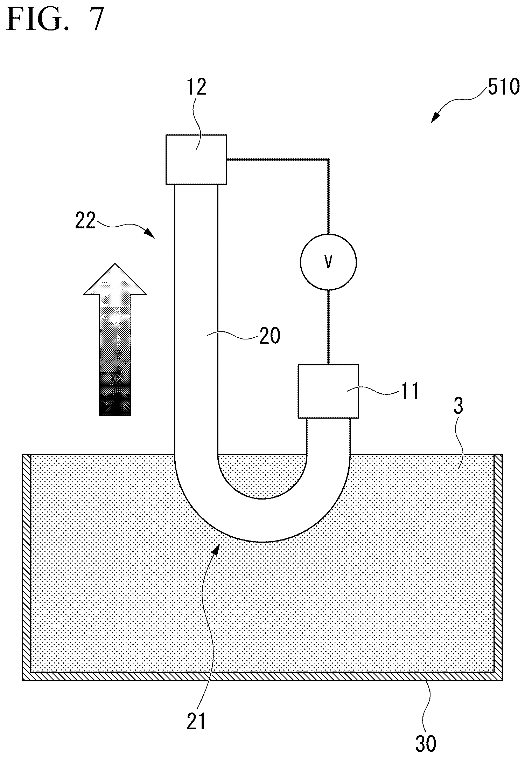

For example, in a case where the distance from the liquid surface to the first electrode portion 11 and the distance from the liquid surface to the second electrode portion 12 are different as in a thermoelectric power generation module 410 shown in FIG. 6 or a thermoelectric power generation module 510 shown in FIG. 7, a temperature difference occurs between the first electrode portion 11 and the second electrode portion 12, and thus power generation can be performed.

In addition, in the first embodiment, the p-type thermoelectric material-containing porous body and the n-type thermoelectric material-containing porous body are connected in series, but either the p-type thermoelectric material-containing porous body or the n-type thermoelectric material-containing porous body may be a conductor. In that case, the conductor may be a thermoelectric material-containing porous body having conductive properties.

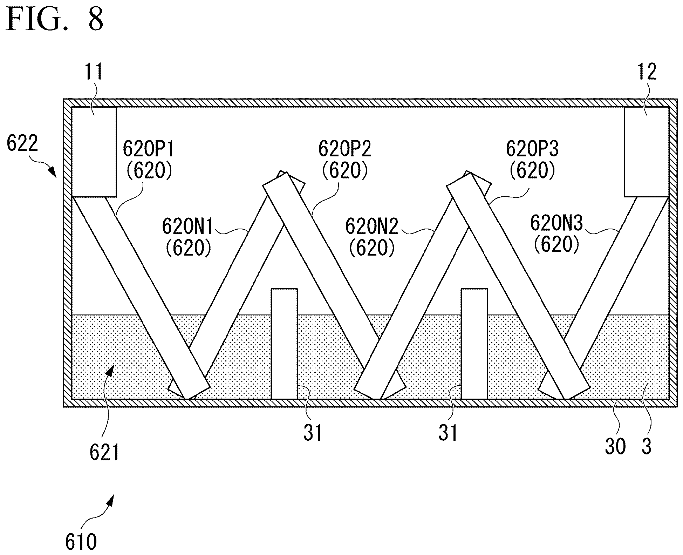

Further, in the first embodiment, the liquid holding portion 30 that holds the liquid 3 is provided, but as in a thermoelectric power generation module 610 shown in FIG. 8, immersion portions 621 of a plurality of thermoelectric material-containing porous bodies 620 (620P1, 620N1, 620P2, 620N2, 620P3, and 620N3) may be immersed, and a partition portion 31 may be formed between the adjacent immersion portions 621 and 621 of the thermoelectric material-containing porous bodies 620 and 620.

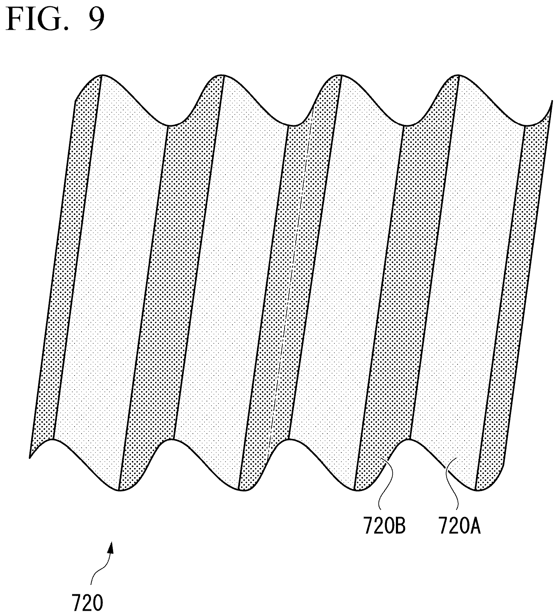

In addition, as shown in FIG. 9, it is preferable that a thermoelectric material-containing porous body 720 includes a porous body having a corrugated structure in which one oblique wall portion 720A and the other oblique wall portion 720B are connected, and at least one oblique wall portion 720A is a thermoelectric material-containing porous body. Note that, the one oblique wall portion 720A may be a p-type thermoelectric material-containing porous body, and the other oblique wall portion 720B may be a p-type thermoelectric material-containing porous body. Alternatively, the one oblique wall portion 720A may be a thermoelectric material-containing porous body (a p-type thermoelectric material-containing porous body or a p-type thermoelectric material-containing porous body), and the other oblique wall portion 720B may be a conductor-containing porous body containing a conductor.

Further, in the second embodiment, the structure in which the thermoelectric material-containing porous bodies 120 are connected to each other by using the first connecting portion 115 and the third connecting portion 117 has been described, but the present invention is not limited thereto, and the thermoelectric material-containing porous bodies 120 may be bonded to each other by using a conductive bonding material (for example, a carbon tape or the like).

Further, in the present embodiment, the thermoelectric material-containing porous body (thermoelectric material-containing paper) in which the porous body is paper has been described, but the present invention is not limited thereto, and a thermoelectric material-containing porous body (thermoelectric material-containing thread) in which the porous body is thread may be used, a thermoelectric material-containing porous body (thermoelectric material-containing cloth) in which the porous body is cloth may be used, or a thermoelectric material-containing porous body (thermoelectric material-containing a lead stick) in which the porous body is a lead stick may be used.

Note that, the thermoelectric material-containing thread (CNT-containing thread) in which carbon nanotube is impregnated as a thermoelectric material can be manufactured by the following method.

A method of containing carbon nanotubes in thread is basically the same as a method such as hand dyeing. It is also possible to employ a method in which base thread is immersed in a carbon nanotube dispersed solution, and the dispersed solution is heated (approximately 60°C) to a certain extent at which the dispersed solution does not boil in this state, and a moisture is evaporated, so that the carbon nanotubes are concentrated and the thread is coated with the carbon nanotubes. According to such an impregnation method, more carbon nanotubes are impregnated in the thread.

Note that, as the base thread (base material) required for manufacturing the CNT-containing thread, natural thread such as cotton thread, hemp thread, wool, or silk, or a synthetic fiber thread such as polyester or nylon derived from chemical synthesis, which is generally used, is used, but mixed thread thereof may be used.

Here, for a type of thread into which a dye does not permeate, such as a synthetic fiber, a CNT-containing thread may be manufactured by applying a carbon nanotube dispersed solution to a surface of the thread and drying the thread.

### Examples

Hereinafter, results of experiments for confirmation performed to confirm the effects of the present invention will be described.

The immersion portion of the thermoelectric power generation module according to the first embodiment was immersed in water, and an open-circuit voltage between the first electrode portion and the second electrode portion was measured. Here, the temperature of stored water and an indoor temperature were adjusted as shown in Table 1. Note that, a temperature difference in Table 1 is obtained by subtracting the room temperature from the water temperature.

**[Table 1]**

| | Room temperature (°C) | Liquid temperature (°C) | Temperature difference (°C) | Open-circuit voltage (mV) |
|---|---|---|---|---|
| Example 1 | 22.3 | 22.3 | 0.0 | 0.167 |
| Example 2 | 22.1 | 20.9 | -1.2 | 0.091 |
| Example 3 | 21.3 | 71.1 | 49.8 | 3.600 |
| Example 4 | 20.9 | 23.8 | 2.9 | 0.453 |

As shown in Examples of the present invention (Examples) 1 to 4 in Table 1, it was confirmed that a potential difference occurred between the first electrode portion and the second electrode portion due to a temperature difference due to heat of vaporization of water, and power generation was performed.

In addition, it was confirmed that by setting the water temperature to be higher than room temperature, the potential difference between the first electrode portion and the second electrode portion was further increased, and power generation was efficiently performed.

### INDUSTRIAL APPLICABILITY

From the above, according to the present invention, it is possible to provide a thermoelectric power generation module that has a simple structure, is easy to handle, and is capable of generating power easily and efficiently.

### REFERENCE SIGNS LIST

3 Liquid
10, 110, 210, 310, 410, 510, 610 Thermoelectric power generation module
11, 111, 211 First electrode portion
12, 112, 212 Second electrode portion
20, 120, 220 Thermoelectric material-containing porous body
21, 121, 221 Immersion portion
22, 122, 222 Non-immersion portion
30 Liquid holding portion
350 Float

## Claims

1. A thermoelectric power generation module comprising:
a thermoelectric material-containing porous body made of a porous body containing a thermoelectric material having an absolute value of a Seebeck coefficient of 3 µV/K or more; and
a first electrode portion and a second electrode portion connected to the thermoelectric material-containing porous body,
wherein one end of the thermoelectric material-containing porous body is an immersion portion that is immersed in a liquid, and the other end of the thermoelectric material-containing porous body is a non-immersion portion, and
the liquid is sucked up in the immersion portion, the liquid which has been sucked up volatilizes in the non-immersion portion, a temperature difference occurs between the one end and the other end of the thermoelectric material-containing porous body due to vaporization heat in volatilization of the liquid, and power is generated by the temperature difference.

2. The thermoelectric power generation module according to Claim 1, wherein the thermoelectric material is a carbon nanotube.

3. The thermoelectric power generation module according to Claim 1, wherein the thermoelectric material is an organic thermoelectric material.

4. The thermoelectric power generation module according to Claim 1, wherein the thermoelectric material is a nanotube or a nanowire formed of a compound semiconductor or a silicon semiconductor.

5. The thermoelectric power generation module according to Claim 1, wherein the porous body is any one of paper, thread, nonwoven fabric, cloth, and a lead stick.

6. The thermoelectric power generation module according to Claim 1, wherein the liquid is a volatile liquid that is volatilizable at normal temperature.

7. The thermoelectric power generation module according to Claim 1, wherein the thermoelectric material-containing porous body includes a p-type thermoelectric material-containing porous body containing a p-type thermoelectric material and an n-type thermoelectric material-containing porous body containing an n-type thermoelectric material, and the p-type thermoelectric material-containing porous body and the n-type thermoelectric material-containing porous body are connected in series.

8. The thermoelectric power generation module according to Claim 1, wherein the thermoelectric material-containing porous body is either a p-type thermoelectric material-containing porous body containing a p-type thermoelectric material or an n-type thermoelectric material-containing porous body containing an n-type thermoelectric material, and a conductor-containing porous body made of a porous body containing a conductor and the thermoelectric material-containing porous body are connected to each other.

9. The thermoelectric power generation module according to Claim 1, further comprising:
a liquid holding portion configured to hold the liquid.

10. The thermoelectric power generation module according to Claim 9, wherein thermoelectric material-containing porous body includes a plurality of the thermoelectric material-containing porous bodies, one end of each of the plurality of the thermoelectric material-containing porous bodies is immersed in the liquid holding portion, and a partition portion is provided between immersion portions of the thermoelectric material-containing porous bodies adjacent to each other.

11. The thermoelectric power generation module according to Claim 1, further comprising:
a float.

12. The thermoelectric power generation module according to Claim 1, wherein the thermoelectric power generation module includes a porous body having a corrugated structure in which one oblique wall portion and the other oblique wall portion are connected to each other, and at least the one oblique wall portion is the thermoelectric material-containing porous body.
